# EUROPEAN PATENT APPLICATION

(11) **EP 2 053 027 A1**
(43) Date of publication of application: **29.04.2009**
(21) Application number: 08016270.4
(22) Date of filing: 16.09.2008
(51) Int. Cl.: C03C 17/00

(54) **Method of making an antireflective silica coating, resulting product, and photovoltaic device comprising same**

(30) Priority: 23.10.2007 US 976320
(71) Applicant: Guardian Industries Corp., Auburn Hills, MI 48326-1714 (US)
(72) Inventor: Sharma, Pramod K., Ann Arbor, Michigan 48105 (US)
(74) Representative: Hess, Peter K. G.

(57) **Abstract**

A low-index silica coating may be made by forming silica sol including or of a silane and/or a colloidal silica. The silica precursor may be deposited on a substrate (e.g., glass substrate) to form a coating layer. The coating layer may then be cured and/or fired using temperature(s) of from about 550 to 700°C. The coating layer includes a striping-reducing agent to inhibit the appearance of striping in the coating layer. The low-index silica based coating may be used as an antire-flective (AR) film on a front glass substrate of a photovoltaic device (e.g., solar cell) or any other suitable application in certain example instances.

## Description

Certain example embodiments of this invention relate to a method of making a low-index silica coating. The coating may comprise an antireflective (AR) coating supported by a glass substrate for use in a photovoltaic device or the like in certain example embodiments. The AR coating may include organics, such as alcohol(s), ether(s), and oleate(s). These organics may reduce or even eliminate striping that may appear in the AR coating after heat treatment.

### Background of the invention

Glass is desirable for numerous properties and applications, including optical clarity and overall visual appearance. For some example applications, certain optical properties (e.g., light transmission, reflection and/or absorption) are desired to be optimized. For example, in certain example instances, reduction of light reflection from the surface of a glass substrate may be desirable for storefront windows, display cases, photovoltaic devices (e.g., solar cells), picture frames, other types of windows, greenhouses, and so forth.

Photovoltaic devices such as solar cells (and modules therefor) are known in the art. Glass is an integral part of most common commercial photovoltaic modules, including both crystalline and thin film types. A solar cell/module may include, for example, a photoelectric transfer film made up of one or more layers located between a pair of substrates. One or more of the substrates may be of glass, and the photoelectric transfer film (typically semiconductor) is for converting solar energy to electricity. Example solar cells are disclosed in U.S. Patent Nos. 4,510,344, 4,806,436, 6,506,622, 5,977,477, and JP 07-122764, the disclosures of which are hereby incorporated herein by reference.

Substrate(s) in a solar cell/module are sometimes made of glass. Incoming radiation passes through the incident glass substrate of the solar cell before reaching the active layer(s) (e.g., photoelectric transfer film such as a semiconductor) of the solar cell. Radiation that is reflected by the incident glass substrate does not make its way into the active layer(s) of the solar cell, thereby resulting in a less efficient solar cell. In other words, it would be desirable to decrease the amount of radiation that is reflected by the incident substrate, thereby increasing the amount of radiation that makes its way to the active layer(s) of the solar cell. In particular, the power output of a solar cell or photovoltaic (PV) module may be dependant upon the amount of light, or number of photons, within a specific range of the solar spectrum that pass through the incident glass substrate and reach the photovoltaic semiconductor.

Because the power output of the module may depend upon the amount of light within the solar spectrum that passes through the glass and reaches the PV semiconductor, certain attempts have been made in an attempt to boost overall solar transmission through the glass used in PV modules. One attempt is the use of iron-free or "clear" glass, which may increase the amount of solar light transmission when compared to regular float glass, through absorption minimization.

In certain example embodiments of this invention, an attempt to address the aforesaid problem(s) is made using an antireflective (AR) coating on a glass substrate (the AR coating may be provided on either side of the glass substrate in different embodiments of this invention). An AR coating may increase transmission of light through the light incident substrate, and thus the power of a PV module in certain example embodiments of this invention.

Porous silica may be commonly used as an AR coating on a glass substrate. In the production of AR coating, striping may appear in the AR coating after curing in the oven and tempering in the furnace. The striping may be caused, at least in party, by metal rollers on which AR coated glass transported to the oven. In many instances, the visibility of the striping may intensify if the wet coating thickness increases. This may be particularly noticeable for AR coating(s) formulated in the solvents with high molecular weight, such as butoxyethanol, methoxypropanol, butanol, etc.

Striping may also occur with lower molecular weight solvents, such as propanol. With lower molecular weight solvents, the appearance of striping may depend on the thickness of the wet coating. Additionally, at the time of scale-up production, a window with large variation in the wet coating thickness may facilitate the optimization of the process in terms of achieving targeted performance.

Accordingly, there may be a need of elimination of striping, e.g., at high wet coating thickness. Certain embodiments of the present invention may relate to the formulation of AR coatings in order to eliminate the striping at high wet thickness, using alcohols, ether and oleates.

### Brief summary of example embodiments of the invention

In certain example embodiments of this invention, there is provided a method of making a low-index silica based coating having minimally visible striping, the method comprising: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate (directly or indirectly "on") to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.

In exemplary embodiments, there is a striping reducing agent that comprises an ether/oleate-based organic. In exemplary embodiments, the striping agent comprises polyoxyethylene(4) lauryl ether, polyoxyethylene (20) sorbitan monooleate, and polyoxyethylene(10) isooctylphenyl ether. In exemplary embodiments, the ether/oleate-based organic comprises up to 2.5%, up to 5%, or up to 10% by weight of the silica sol.

In exemplary embodiments, the striping reducing agent comprises at least 50% ethanol by weight. In exemplary embodiments, the striping reducing agent comprises a low molecular weight solvent comprises ethanol.

In certain exemplary embodiments of this invention, there is a method of making a photovoltaic device comprising a photoelectric transfer film, at least one electrode, and the low-index coating, wherein the method of making the photovoltaic device comprises making the low-index coating including a striping-reducing agent, and wherein the low-index coating is provided on a light incident side of a front glass substrate of the photovoltaic device.

In certain exemplary embodiments of this invention, there is a method of making a photovoltaic device including a low-index silica based coating used in an antireflective coating, the method comprising: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing; and using the glass substrate with the low-index silica based coating thereon as a front glass substrate of the photovoltaic device so that the low-index silica based coating is provided on a light incident side of the glass substrate.

In certain exemplary embodiments of this invention, there is a photovoltaic device comprising: a photovoltaic film, and at least a glass substrate on a light incident side of the photovoltaic film; an antireflection coating provided on the glass substrate; wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.

In exemplary embodiments of this invention, there is a coated article comprising: a glass substrate; an antireflection coating provided on the glass substrate; wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.

### Brief description of the drawings

- Figure 1: is a cross sectional view of a coated article including an antireflective (AR) coating made in accordance with an example embodiment of this invention (this coated article of Fig. 1 may be used in connection with a photovoltaic device or in any other suitable application in different embodiments of this invention).
- Figure 2: is a cross sectional view of a photovoltaic device that may use the AR coating of Figure 1.
- Figure 3: illustrates striping in an AR coating.

### Detailed description of exemplary embodiments of the invention

In exemplary embodiments, certain aspects of this invention may relate to the use of organics, such as alcohol(s), ether(s) and oleate(s) in the formulation of an AR coating. These organics may minimize or even eliminate the appearance of striping in an AR coating on glass that occurs after the heat treatment. Such a coating could be deposited on glass used as a superstrate for the production of photovoltaic devices. These coatings may also be temperable. In some embodiments, there may be an unusually high wet thickness of the coating that may be achieved through the use of mixture of alcohols and/or ether/oleate based organics in the formulation without showing striping.

Referring now more particularly to the accompanying drawings in which like reference numerals indicate like parts throughout the several views.

This invention relates to antireflective (AR) coatings that may be provided for in coated articles used in devices such as photovoltaic devices, storefront windows, display cases, picture frames, greenhouses, other types of windows, and the like. In certain example embodiments (e.g., in photovoltaic devices), the AR coating may be provided on either the light incident side or the other side of a substrate (e.g., glass substrate), such as a front glass substrate of a photovoltaic device. In other example embodiments, the AR coatings described herein may be used in the context of sport and stadium lighting (as an AR coating on such lights), and/or street and highway lighting (as an AR coating on such lights).

In certain example embodiments of this invention, an improved anti-reflection (AR) coating is provided on an incident glass substrate of a solar cell or the like. This AR coating may function to reduce reflection of light from the glass substrate, thereby allowing more light within the solar spectrum to pass through the incident glass substrate and reach the photovoltaic semiconductor so that the solar cell can be more efficient. In other example embodiments of this invention, such an AR coating is used in applications other than photovoltaic devices (e.g., solar cells), such as in storefront windows, display cases, picture frames, greenhouse glass/windows, solariums, other types of windows, and the like. The glass substrate may be a glass superstrate or any other type of glass substrate in different instances.

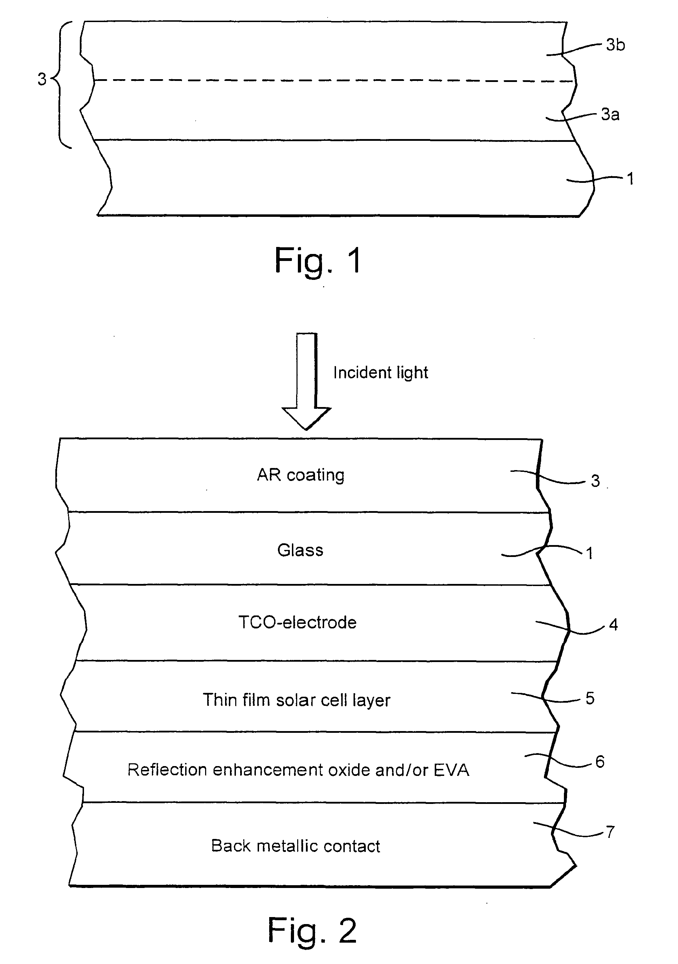

Figure 1 is a cross sectional view of a coated article according to an example embodiment of this invention. The coated article of Figure 1 includes a glass substrate 1 and an AR coating 3. The AR coating includes a first layer 3a and an optional overcoat layer 3b.

In the Fig. 1 embodiment, the antireflective coating 3 includes first layer 3a comprising a silane and/or a colloidal silica. The first layer 3a may be any suitable thickness in certain example embodiments of this invention. However, in certain example embodiments, the first layer 3a of the AR coating 3 has a thickness of approximately 500 to 4000 Å after firing.

The AR coating 3 may also include an surface treatment layer 3b of or including a surface treatment composition, which is provided over the first layer 3a in certain example embodiments of this invention as shown in Fig. 1. It is possible to form other layer(s) between layers 3a and 3b, and/or between glass substrate 1 and layer 3a, in different example embodiments of this invention.

In certain example embodiments of this invention, high transmission low-iron glass may be used for glass substrate 1 in order to further increase the transmission of radiation (e.g., photons) to the active layer of the solar cell or the like. For example and without limitation, the glass substrate 1 may be of any of the glasses described in any of U.S. Patent Application Serial Nos. 11/049,292 and/or 11/122,218, the disclosures of which are hereby incorporated herein by reference. Furthermore, additional suitable glasses include, for example (i.e., and without limitation): standard clear glass; and/or low-iron glass, such as Guardian's ExtraClear, UltraWhite, or Solar. No matter the composition of the glass substrate, certain embodiments of anti-reflective coatings produced in accordance with the present invention may increase transmission of light to the active semiconductor film of the photovoltaic device.

Certain glasses for glass substrate 1 (which or may not be patterned in different instances) according to example embodiments of this invention utilize soda-lime-silica flat glass as their base composition/glass. In addition to base composition/glass, a colorant portion may be provided in order to achieve a glass that is fairly clear in color and/or has a high visible transmission. An exemplary soda-lime-silica base glass according to certain embodiments of this invention, on a weight percentage basis, includes the following basic ingredients: SiO2, 67-75% by weight; Na2O, 10-20% by weight; CaO, 5-15% by weight; MgO, 0-7% by weight; Al2O3, 0-5% by weight; K2O, 0-5% by weight; Li2O, 0-1.5% by weight; and BaO, 0-1%, by weight.

Other minor ingredients, including various conventional refining aids, such as SO3, carbon, and the like may also be included in the base glass. In certain embodiments, for example, glass herein may be made from batch raw materials silica sand, soda ash, dolomite, limestone, with the use of sulfate salts such as salt cake (Na2SO4 and/or Epsom salt (MgSO4 x 7H2O) and/or gypsum (e.g., about a 1:1 combination of any) as refining agents. In certain example embodiments, soda-lime-silica based glasses herein include by weight from about 10-15% Na2O and from about 6-12% CaO, by weight.

In addition to the base glass above, in making glass according to certain example embodiments of the instant invention the glass batch includes materials (including colorants and/or oxidizers) which cause the resulting glass to be fairly neutral in color (slightly yellow in certain example embodiments, indicated by a positive b* value) and/or have a high visible light transmission. These materials may either be present in the raw materials (e.g., small amounts of iron), or may be added to the base glass materials in the batch (e.g., cerium, erbium and/or the like). In certain example embodiments of this invention, the resulting glass has visible transmission of at least 75%, more preferably at least 80%, even more preferably of at least 85%, and most preferably of at least about 90% (Lt D65). In certain example non-limiting instances, such high transmissions may be achieved at a reference glass thickness of about 3 to 4 mm In certain embodiments of this invention, in addition to the base glass, the glass and/or glass batch comprises or consists essentially of materials as set forth in Table 1 below (in terms of weight percentage of the total glass composition):

**Table 1: Example Additional Materials In Glass**

| Ingredient | General (Wt.%) | More Preferred | Most Preferred |
|---|---|---|---|
| total iron (expressed as Fe₂O₃): | 0.001 - 0.06 % | 0.005 - 0.04 % | 0.01 - 0.03 % |
| cerium oxide: | 0 - 0.30 % | 0.01 - 0.12 % | 0.01 - 0.07 % |
| TiO₂ | 0 - 1.0% | 0.005 - 0.1% | 0.01 - 0.04% |
| Erbium oxide | 0.05 to 0.5% | 0.1 to 0.5% | 0.1 to 0.35% |

In certain example embodiments, the total iron content of the glass is more preferably from 0.01 to 0.06%, more preferably from 0.01 to 0.04%, and most preferably from 0.01 to 0.03%. In certain example embodiments of this invention, the colorant portion is substantially free of other colorants (other than potentially trace amounts). However, it should be appreciated that amounts of other materials (e.g., refining aids, melting aids, colorants and/or impurities) may be present in the glass in certain other embodiments of this invention without taking away from the purpose(s) and/or goal(s) of the instant invention. For instance, in certain example embodiments of this invention, the glass composition is substantially free of, or free of, one, two, three, four or all of: erbium oxide, nickel oxide, cobalt oxide, neodymium oxide, chromium oxide, and selenium. The phrase "substantially free" means no more than 2 ppm and possibly as low as 0 ppm of the element or material. It is noted that while the presence of cerium oxide is preferred in many embodiments of this invention, it is not required in all embodiments and indeed is intentionally omitted in many instances. However, in certain example embodiments of this invention, small amounts of erbium oxide may be added to the glass in the colorant portion (e.g., from about 0.1 to 0.5% erbium oxide).

The total amount of iron present in the glass batch and in the resulting glass, i.e., in the colorant portion thereof, is expressed herein in terms of Fe2O3 in accordance with standard practice. This, however, does not imply that all iron is actually in the form of Fe2O3 (see discussion above in this regard). Likewise, the amount of iron in the ferrous state (Fe+2) is reported herein as FeO, even though all ferrous state iron in the glass batch or glass may not be in the form of FeO. As mentioned above, iron in the ferrous state (Fe2+; FeO) is a blue-green colorant, while iron in the ferric state (Fe3+) is a yellow-green colorant; and the blue-green colorant of ferrous iron is of particular concern, since as a strong colorant it introduces significant color into the glass which can sometimes be undesirable when seeking to achieve a neutral or clear color.

It is noted that the light-incident surface of the glass substrate 1 may be flat or patterned in different example embodiments of this invention.

Fig. 2 is a cross-sectional view of a photovoltaic device (e.g., solar cell), for converting light to electricity, according to an example embodiment of this invention. The solar cell of Fig. 2 uses the AR coating 3 and glass substrate 1 shown in Fig. 1 in certain example embodiments of this invention. In this example embodiment, the incoming or incident light from the sun or the like is first incident on the surface of the AR coating 3, passes therethrough and then through glass substrate 1 and front transparent electrode 4 before reaching the photovoltaic semiconductor (active film) 5 of the solar cell. Note that the solar cell may also include, but does not require, a reflection enhancement oxide and/or EVA film 6, and/or a back metallic contact and/or reflector 7 as shown in example Fig. 2. Other types of photovoltaic devices may of course be used, and the Fig. 2 device is merely provided for purposes of example and understanding. As explained above, the AR coating 3 reduces reflections of the incident light and permits more light to reach the thin film semiconductor film 5 of the photovoltaic device thereby permitting the device to act more efficiently.

While certain of the AR coatings 3 discussed above are used in the context of the photovoltaic devices/modules, this invention is not so limited. AR coatings according to this invention may be used in other applications such as for picture frames, fireplace doors, greenhouses, and the like. Also, other layer(s) may be provided on the glass substrate under the AR coating so that the AR coating is considered on the glass substrate even if other layers are provided therebetween. Also, while the first layer 3a is directly on and contacting the glass substrate 1 in the Fig. 1 embodiment, it is possible to provide other layer(s) between the glass substrate and the first layer in alternative embodiments of this invention.

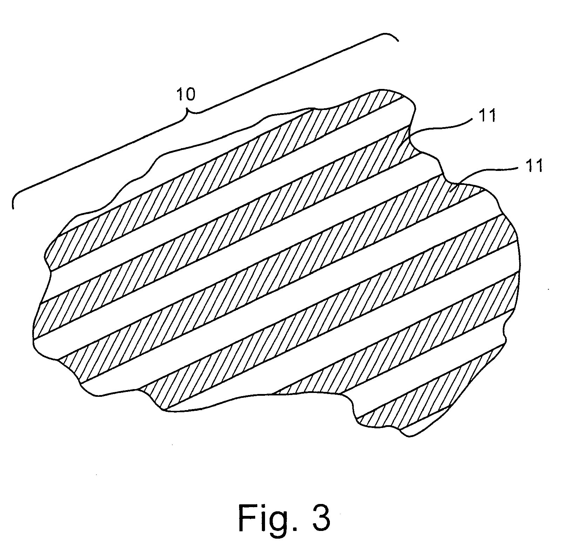

Figure 3 illustrates striping in the AR coating that may be present in prior art coated substrates. The stripes 11 may be visible when coated substrate 10 is viewed after firing.

Exemplary embodiments of this invention provide a new method to produce a low index silica coating for use as the AR coating 3, with appropriate light transmission and abrasion resistance properties. Exemplary embodiments of this invention provide a method of making a coating containing a stabilized colloidal silica for use in coating 3. In certain example embodiments of this invention, the coating may be based, at least in part, on a silica sol comprising two different silica precursors, namely (a) a stabilized colloidal silica including or consisting essentially of particulate silica in a solvent and (b) a polymeric solution including or consisting essentially of silica chains.

In making the polymeric silica solution, a silane may be mixed with a catalyst, solvent and water. After agitating, the colloidal silica solution (a) is added to the polymeric silica solution (b), optionally with a solvent. The sol gel coating solution is then deposited on a suitable substrate such as a highly transmissive clear glass substrate. Then, the sol gel coating solution on the glass 1 substrate is cured and/or fired, preferably from about 100 to 750°C, and all subranges therebetween, thereby forming the solid AR coating 3 on the glass substrate 1. The final thickness of the AR coating 3 may, though not necessarily, be approximately a quarter wave thickness in certain example embodiments of this invention. It has been found that an AR coating made in such a manner may have adequate durability

In certain embodiments of the present invention, the silica sol further comprises organics, such as alcohol(s), ether(s), and oleate(s). These organics may reduce or even eliminate striping that may appear in the AR coating after heat treatment. In some embodiments, this AR coating has been formulated using solvent mixture and an ether/oleate-based organic such as polyoxyethylene(4) lauryl ether (PLE), polyoxyethylene (20) sorbitan monooleate (PSM), and polyoxyethylene(10) isooctylphenyl ether (PPE). In further exemplary embodiments, the striping agent comprises a polyoxyethylene ether of butyl alcohol; a polyoxyethylene ether of amyl alcohol; a polyoxyethylene ether of octyl alcohol; a polyoxyethylene ether of decyl alcohol; a polyoxyethylene ether of nonyl alcohol; a polyoxyethylene olyle ether; a polyoxyethylene thioether of oleyl alcohol; a polyoxyethylene dithionoleate; a mono-oleate of ethylene glycol; a dioleate of Polyethylene glycol; a monooleate of diethylene glycol; a mono oleate of glcycerols; or a polyoxyethylene glycery oleates. These solvent-organic mixtures may minimize or eliminate the appearance of striping after heat treatment to 220°C and 625°C.

In certain embodiments, the silica sol may comprise up to 10% (and all lesser included amounts, e.g., 5% and 2.5%) by weight of the ether/oleate-based organic.

In accordance with certain embodiments of the present invention, suitable solvents may include, for example, n-propanol, isopropanol, other well-known alcohols (e.g., ethanol), and other well-known organic solvents (e.g., toluene). In certain embodiments, the silica sol may comprise a low-molecular weight solvent, such as ethanol, to reduce, minimize or eliminate the appearance of striping after heat treatment. In some embodiments, the low-molecular weight solvent comprises greater than 50% (e.g., greater than 75%) ethanol by weight.

Suitable catalysts may include, for example, well-known acids, such as hydrochloric acid, sulfuric acid, etc. The colloidal silica may comprise, for example, silica and methyl ethyl ketone. The curing may occur at a temperature between 100 and 150°C for up to 2 minutes, and the heat treating may occur at a temperature between 600 and 750°C for up to 5 minutes. Shorter and longer times with higher and lower temperatures are contemplated within exemplary embodiments of the present invention.

In exemplary embodiments, silica precursor materials may be optionally combined with solvents, anti-foaming agents, surfactants, etc., to adjust rheological characteristics and other properties as desired. In a preferred embodiment, use of reactive diluents may be used to produce formulations containing no volatile organic matter. Some embodiments may comprise colloidal silica dispersed in monomers or organic solvents. Depending on the particular embodiment, the weight ratio of colloidal silica and other silica precursor materials may be varied. Similarly (and depending on the embodiment), the weight percentage of solids in the coating formulation may be varied.

Several examples were prepared, so as to illustrate exemplary embodiments of the present invention. Although the examples describe the use of the draw down bar method, the uncured coating may be deposited in any suitable manner, including, for example, spin-coating method, roller-coating, spray-coating, and any other method of depositing the uncured coating on a substrate.

In certain exemplary embodiments, the firing may occur in an oven at a temperature ranging preferably from 550 to 700°C (and all subranges therebetween), more preferably from 575 to 675°C (and all subranges therebetween), and even more preferably from 600 to 650°C (and all subranges therebetween). The firing may occur for a suitable length of time, such as between 1 and 10 minutes (and all subranges therebetween) or between 3 and 7 minutes (and all subranges therebetween).
Set forth below is a description of how AR coating 3 may be made according to certain example non-limiting embodiments of this invention. Except where noted otherwise, the supplier for components in the following examples are available from Aldrich.

### Example #1

The silica sol was prepared as follows. A polymeric component of silica was prepared by using 64%wt of n-propanol, 24%wt of glycydoxylpropyltrimethoxysilane (Glymo), 7%wt of water and 5%wt of hydrochloric acid. These ingredients were used and mixed for 24 hrs. The coating solution was prepared by using 21%wt of polymeric solution, 7%wt colloidal silica in methyl ethyl ketone supplied by Nissan Chemicals Inc, and 72%wt n-propanol. This was stirred for 2hrs to give a silica sol. The final solution is referred to as silica sol.

The silica coating was fabricated using the draw down bar method. The coating was dried at room temperature for 2 minutes then cured in oven at 220°C for 2.5 minutes and tempered in belt furnace at 625°C for 10 minutes. The striping does not appear at a wet thickness of 10 µm when heated to 220°C and 625°C.

### Example #2

The silica sol was prepared as follows. A polymeric component of silica was prepared by using 64%wt of solvent mixture containing 90%wt of n-propanol and 10%wt of ethanol, 24%wt of glycydoxylpropyltrimethoxysilane (Glymo), 7%wt of water and 5%wt of hydrochloric acid. These ingredients were used and mixed for 24 hrs. The coating solution was prepared by using 21%wt of polymeric solution, 7%wt colloidal silica in methyl ethyl ketone supplied by Nissan Chemicals Inc, and 72%wt of solvent mixture containing 90%wt of n-propanol and 10%wt of ethanol. This was stirred for 2hrs to give silica sol. The final solution is referred to as silica sol.

The silica coating was fabricated using the draw down bar method. The coatings were dried and heat treated as mentioned in the example #1. The striping does not appear at a wet thickness of 10 µm when heated to 220°C and 625°C.

### Example #3

The example #3 is same as example #2 except the solvent mixture contained 50%wt of n-propanol and 50%wt of ethanol. The silica coating was fabricated using the draw down bar method. The coatings were dried and heat treated as mentioned in the example #1. The striping does not appear at a wet thickness of 10 µm when heated to 220°C and 625°C.

### Example #4

The example #4 is same as example #2 except the solvent mixture contained 25%wt of n-propanol and 75%wt of ethanol. The silica coating was fabricated using the draw down bar method. The coatings were dried and heat treated as mentioned in the example #1. The striping does not appear at a wet thickness of 50 µm when heated to 220°C and 30 µm when heated to 625°C.

### Example #5

The example #5 is same as example #2 except the solvent mixture contained 10%wt of n-propanol and 90%wt of ethanol. The silica coating was fabricated using the draw down bar method. The coatings were dried and heat treated as mentioned in the example #1. coating was dry at room temperature for 2 minutes and then cured in oven at 220°C for 2.5 minutes. The striping does not appear at a wet thickness of 50 µm when heated to 220°C and 50 µm when heated to 625°C.

### Example #6

The example #6 is same as example #1 except the solvent taken was 100% ethanol. The silica coating was fabricated using the draw down bar method. The coatings were dried and heat treated as mentioned in the example #1. The striping does not appear at a wet thickness of 70 µm when heated to 220°C and 50 µm when heated to 625°C.

### Example #7

In example #7, the silica sol (prepared as in example #1) was taken 97.5%wt and mixed with 2.5%wt of polyoxyethylene(4) lauryl ether (PLE). The solution was mixed for 30 minutes. The silica coating was fabricated using the draw down bar method. The coatings were dried and heat treated as mentioned in the example #1. The striping does not appear at a wet thickness of 10 µm when heated at 220°C and 625°C.

### Example #8

The example #8 is same as example #7 except the silica sol was taken 95%wt and mixed with 5%wt of polyoxyethylene(4) lauryl ether (PLE). The solution was mixed for 30 minutes. The silica coating was fabricated using the draw down bar method. The coatings were dried and heat treated as mentioned in the example #1. The striping does not appear at a wet thickness of 10 µm when heated at 220°C and 625°C.

### Example #9

The example #9 is same as example #7 except the silica sol was taken 97.5%wt and mixed with 2.5%wt of polyoxyethylene(20) sorbitan monooleate (PSM). The solution was mixed for 30 minutes. The silica coating was fabricated using the draw down bar method. The coatings were dried and heat treated as mentioned in the example #1. The striping does not appear at a wet thickness of 10 µm when heated at 220°C and 625°C.

### Example #10

The example #10 is same as example #7 except the silica sol was taken 95%wt and mixed with 5%wt of polyoxyethylene(20) sorbitan monooleate (PSM). The solution was mixed for 30 minutes. The silica coating was fabricated using the draw down bar method. The coatings were dried and heat treated as mentioned in the example #1. The striping does not appear at a wet thickness of 30 µm when heated at 220°C and 625°C.

### Example #11

The example #11 is same as example #7 except the silica sol was taken 97.5%wt and mixed with 2.5%wt of polyoxyethylene(10) isooctylphenyl ether (PPE). The solution was mixed for 30 minutes. The silica coating was fabricated using the draw down bar method. The coatings were dried and heat treated as mentioned in the example #1. The striping does not appear at a wet thickness of 10 µm when heated at 220°C and 625°C.

### Example #12

The example #10 is same as example #7 except the silica sol was taken 95%wt and mixed with 5%wt of polyoxyethylene(10) isooctylphenyl ether (PPE). The solution was mixed for 30 minutes. The silica coating was fabricated using the draw down bar method. The coatings were dried and heat treated as mentioned in the example #1. The striping does not appear at a wet thickness of 50 µm when heated at 220°C and 30 µm when heated at 625°C.

**Table 2: Appearance of striping in coating derived from different solvents, solvent mixtures and organics.**

| Example No. | Solvent 1 | Solvent 2 | Organic Chemical | Wet Thickness (µm) | |
|---|---|---|---|---|---|
| | Propanol (%Wt) | Ethanol (%Wt) | | No Striping at 220°C | No Striping at 625°C |
| Example #1 | 100 | 0 | 0 | 10 | 10 |
| Example #2 | 90 | 10 | 0 | 10 | 10 |
| Example #3 | 50 | 50 | 0 | 10 | 10 |
| Example #4 | 25 | 75 | 0 | 50 | 30 |
| Example #5 | 10 | 90 | 0 | 50 | 50 |
| Example #6 | 0 | 100 | 0 | 70 | 50 |
| Example #7 | 97.5 | 0 | 2.5%wt | 10 | 10 |
| Example #8 | 95 | 0 | PLE | 10 | 10 |
| Example #9 | 97.5 | 0 | 2.5%wt | 10 | 10 |
| Example #10 | 95 | 0 | PSM | 30 | 30 |
| Example #11 | 97.5 | 0 | 2.5%wt | 10 | 10 |
| Example #12 | 95 | 0 | PPE | 50 | 30 |

The examples show that a coating derived from high molecular weight solvent such as propanol which contains oleates such as polyoxyethylene(20) sorbitan monooleate, may be striping free after heating at 220°C and 625°C at the wet thickness of 30 µm.

The examples further show that a coating derived from high molecular weight solvent such as propanol which contains ether such as polyoxyethylene (10) isooctylphenyl ether, may be striping free after heating at 220°C and 625°C at the wet thickness of 50 µm and 30 µm respectively.

The examples also show that a coating a derived from a mixture of propanol and ethanol may be striping free after heating at 220°C and 625°C at the wet thickness of 50 µm.

In addition, the examples show that a solvent with low molecular weight, such as ethanol, may eliminate the striping in the coatings at a higher wet thickness up to 70 µm at 220°C and 50 µm at 625°C.

All described and claimed numerical values and ranges are approximate and include at least some degree of variation.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the spirit and scope of the appended claims.

In the following further preferred embodiments are described to facilitate understanding:
1. A method of making a low-index silica based coating having minimally visible striping, the method comprising:
   forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent;
   depositing the silica precursor on a glass substrate to form a coating layer; and curing and/or firing the coating layer in an oven at a temperature of at least about 550 degrees C for a duration of from about 1 to 10 minutes;
   wherein the striping reducing agent reduces a visible amount of striping on the coating after curing and/or firing.
2. The method of 1, wherein the striping reducing agent comprises an ether/oleate-based organic.
3. The method of 2, wherein the ether/oleate-based organic comprises polyoxyethylene(4) lauryl ether, polyoxyethylene (20) sorbitan monooleate, and polyoxyethylene(10) isooctylphenyl ether.
4. The method of 1, wherein the striping reducing agent comprises at least 50% ethanol by weight.
5. The method of 1, wherein the low molecular weight solvent comprises ethanol.
6. The method of 1, wherein the silica sol comprises up to 10% by weight of the ether/oleate-based organic.
7. The method of 1, wherein the silica sol comprises up to 5% by weight of the ether/oleate-based organic.
8. The method of 1, wherein the silica sol comprises up to 2.5% by weight of the ether/oleate-based organic.
9. A method of making a photovoltaic device comprising a photoelectric transfer film, at least one electrode, and the low-index coating, wherein the method of making the photovoltaic device comprises making the low-index coating according to claim 1, and wherein the low-index coating is provided on a light incident side of a front glass substrate of the photovoltaic device.
10. A method of making a photovoltaic device including a low-index silica based coating used in an antireflective coating, the method comprising:
   forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent;
   depositing the silica precursor on a glass substrate to form a coating layer; and curing and/or firing the coating layer in an oven at a temperature of from about 550 to 700°C for a duration of from about 1 to 10 minutes;
   wherein the striping reducing agent minimizes a visible amount of striping on the coating after curing and/or firing; and
   using the glass substrate with the low-index silica based coating thereon as a front glass substrate of the photovoltaic device so that the low-index silica based coating is provided on a light incident side of the glass substrate.
11. The method of 10, wherein the striping reducing agent comprises an ether/oleate-based organic.
12. The method of 11, wherein the ether/oleate-based organic comprises polyoxyethylene(4) lauryl ether, polyoxyethylene (20) sorbitan monooleate, and polyoxyethylene(10) isooctylphenyl ether.
13. The method of 10, wherein the striping reducing agent comprises at least 50% ethanol by weight.
14. The method of 10, wherein the low molecular weight solvent comprises ethanol.
15. The method of 10, wherein the silica sol comprises up to 5% by weight of the ether/oleate-based organic.
16. A photovoltaic device comprising:
   a photovoltaic film, and at least a glass substrate on a light incident side of the photovoltaic film;
   an antireflection coating provided on the glass substrate;
   wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.
17. The photovoltaic device of 16, wherein the striping reducing agent comprises an ether/oleate-based organic.
18. The photovoltaic device of 17, wherein the ether/oleate-based organic comprises polyoxyethylene(4) lauryl ether, polyoxyethylene (20) sorbitan monooleate, and polyoxyethylene(10) isooctylphenyl ether.
19. The photovoltaic device of 16, wherein the striping reducing agent comprises at least 50% ethanol by weight.
20. A coated article comprising:
   a glass substrate;
   an antireflection coating provided on the glass substrate;
   wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.
21. The coated article of 20, wherein the striping reducing agent comprises an ether/oleate-based organic.
22. The coated article of 21, wherein the ether/oleate-based organic comprises polyoxyethylene(4) lauryl ether, polyoxyethylene (20) sorbitan monooleate, and polyoxyethylene(10) isooctylphenyl ether.
23. The coated article of 20, wherein the striping reducing agent comprises at least 50% ethanol by weight.

## Claims

1. A method of making a low-index silica based coating having minimally visible striping, the method comprising:
forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent;
depositing the silica precursor on a glass substrate to form a coating layer; and
curing and/or firing the coating layer in an oven at a temperature of at least about 550 degrees C for a duration of from about 1 to 10 minutes;
wherein the striping reducing agent reduces a visible amount of striping on the coating after curing and/or firing.

2. The method of claim 1, wherein the striping reducing agent comprises an ether/oleate-based organic, and wherein the ether/oleate-based organic preferably comprises polyoxyethylene(4) lauryl ether, polyoxyethylene (20) sorbitan monooleate, and polyoxyethylene(10) isooctylphenyl ether.

3. The method of claim 1, wherein the striping reducing agent comprises at least 50% ethanol by weight.

4. The method of claim 1, wherein the low molecular weight solvent comprises ethanol.

5. The method of claim 1, wherein the silica sol comprises up to 10% by weight of the ether/oleate-based organic, preferably up to 5% by weight of the ether/oleate-based organic, most preferably up to 2.5% by weight of the ether/oleate-based organic.

6. A method of making a photovoltaic device comprising a photoelectric transfer film, at least one electrode, and the low-index coating, wherein the method of making the photovoltaic device comprises making the low-index coating according to claim 1, and wherein the low-index coating is provided on a light incident side of a front glass substrate of the photovoltaic device.

7. A method of making a photovoltaic device including a low-index silica based coating used in an antireflective coating, the method comprising:
forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent;
depositing the silica precursor on a glass substrate to form a coating layer; and
curing and/or firing the coating layer in an oven at a temperature of from about 550 to 700°C for a duration of from about 1 to 10 minutes;
wherein the striping reducing agent minimizes a visible amount of striping on the coating after curing and/or firing; and
using the glass substrate with the low-index silica based coating thereon as a front glass substrate of the photovoltaic device so that the low-index silica based coating is provided on a light incident side of the glass substrate.

8. The method of claim 7, wherein the striping reducing agent comprises an ether/oleate-based organic, and wherein the ether/oleate-based organic preferably comprises polyoxyethylene(4) lauryl ether, polyoxyethylene (20) sorbitan monooleate, and polyoxyethylene(10) isooctylphenyl ether.

9. The method of claim 7, wherein the striping reducing agent comprises at least 50% ethanol by weight.

10. The method of claim 7, wherein the silica sol comprises up to 5% by weight of the ether/oleate-based organic.

11. A photovoltaic device comprising:
a photovoltaic film, and at least a glass substrate on a light incident side of the photovoltaic film;
an antirefiection coating provided on the glass substrate;
wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.

12. The photovoltaic device of claim 11, wherein the striping reducing agent comprises an ether/oleate-based organic, and wherein the ether/oleate-based organic preferably comprises polyoxyethylene(4) lauryl ether, polyoxyethylene (20) sorbitan monooleate, and polyoxyethylene( 10) isooctylphenyl ether.

13. The photovoltaic device of claim 11, wherein the striping reducing agent comprises at least 50% ethanol by weight.

14. A coated article comprising:
a glass substrate;
an antireflection coating provided on the glass substrate;
wherein the antireflection coating comprises at least a layer provided directly on and contacting the glass substrate, the layer produced using a method comprising the steps of: forming a silica precursor comprising a silica sol comprising a silane and/or a colloidal silica, wherein the silica sol comprises a striping-reducing agent comprising a high-molecular weight solvent and an ether/oleate-based organic or a low-molecular weight solvent; depositing the silica precursor on a glass substrate to form a coating layer; and curing and/or firing the coating layer in an oven at a temperature of from about 550 to 700°C for a duration of from about 1 to 10 minutes; wherein the striping reducing agent minimizes a visible amount of striping on the coating after curing and/or firing.

15. The coated article of claim 14, wherein the striping reducing agent comprises an ether/oleate-based organic, and wherein theether/oleate-based organic preferably comprises polyoxyethylene(4) lauryl ether, polyoxyethylene (20) sorbitan monooleate, and polyoxyethylene(10) isooctylphenyl ether.
